Europäisches Patentamt

European Patent Office

Office européen des brevets

(19)

(11) **EP 0 504 060 B1**

(12) **FASCICULE DE BREVET EUROPEEN**

(45) Date de publication et mention
de la délivrance du brevet:
**19.06.1996 Bulletin 1996/25**

(51) Int Cl.⁶: **H04L 5/14**, H03F 3/62, H04B 1/58

(21) Numéro de dépôt: **92400659.6**

(22) Date de dépôt: **12.03.1992**

(54) **Procédé et circuit de détection de transmission pour liaisons différentielles bi-directionnelles**

Verfahren und Schaltung zur Übertragungsdetektion für bidirektionale, differenzielle Strecke

Method and circuit for transmission detection in bidirectional differential links

(84) Etats contractants désignés:
**BE DE FR GB GR IT LU PT**

(30) Priorité: **14.03.1991 FR 9103127**
**27.06.1991 FR 9108001**

(43) Date de publication de la demande:
**16.09.1992 Bulletin 1992/38**

(73) Titulaire: **BULL S.A.**
**F-78430 Louveciennes (FR)**

(72) Inventeur: **Marbot, Roland**
**F-75116 Paris (FR)**

(74) Mandataire: **Colombe, Michel et al**
**Direction de la Propriété Intellectuelle BULL SA**
**Poste courrier:LV 59C18**
**68 route de Versailles**
**78430 Louveciennes (FR)**

(56) Documents cités:
**EP-A- 0 220 626**     **US-A- 3 700 831**
**US-A- 3 909 559**

## Description

L'invention se situe dans le domaine des transmissions de données numériques entre stations ou unités par l'intermédiaire de liaisons série bi-directionnelles de type point à point et utilisant des lignes de transmission différentielles.

Ces lignes peuvent être des paires torsadées ou des câbles coaxiaux reliés à chaque extrémité à une station par un émetteur et un récepteur associés à la station.

Pour de nombreuses applications, on préfère utiliser un mode de transmission autorisant une émission simultanée dans les deux stations afin d'obtenir une meilleure utilisation des lignes. Le document EP-A-0220626 décrit une émission simultanée pour des circuits n'utilisant pas de lignes de transmission différentielles.

Comme exemple d'application particulièrement adaptée, on peut citer l'interconnexion entre les unités d'un sous-système central informatique comportant un grand nombre d'unités. En effet, lorsque le nombre de processeurs et de mémoires devient important, la solution du bus pour effectuer les échanges d'informations entre toutes ces unités n'est plus adaptée. Il est donc préférable, dans ce contexte, d'utiliser des liaisons série reliant chaque unité à toutes les autres de façon à augmenter le parallélisme. Compte tenu du grand nombre de liaisons impliquées dans un tel système, le choix de liaisons bi-directionnelles du type défini ci-dessus est préférable.

Du point de vue réalisation, une telle transmission bi-directionnelle nécessite au niveau de chaque station la présence d'une émetteur-récepteur relié aux lignes par des impédances d'adaptation. D'autre part, la partie réceptrice comporte des moyens permettant de traiter les collisions, c'est-à-dire les cas où les émetteurs des deux stations reliées entre elles émettent simultanément sur la liaison commune. Ces moyens sont conçus pour permettre en toutes circonstances de détecter à partir de l'état électrique de la ligne l'existence et la nature des signaux émis par la station éloignée.

Pour résoudre ce problème, on utilise habituellement le principe d'une compensation dans le récepteur de l'effet produit sur la ligne par l'émetteur de la même station lorsque celui-ci émet. Ainsi, en cas d'émission, on effectue une soustraction du signal d'émission au signal présent sur la ligne. La différence obtenue est alors représentative du signal émis par l'émetteur de la station éloignée. Cette réalisation est par exemple décrite dans la demande de brevet européen EP-A-186142 intitulée "Two-wire bi-directional digital transmission system".

Une autre solution (voir, par exemple, la demande EP-A-0 504 603 ayant les mêmes dates de dépôt et publication que la présente demande) consiste non pas à soustraire du signal de ligne le signal d'émission lorsque l'émetteur de la station considérée émet, mais au contraire à additionner, lorsque la station n'émet pas, le signal de ligne à un signal de compensation de même polarité convenablement choisi pour que la somme en résultant soit représentative du seul signal d'émission de l'autre station.

Bien entendu, ces moyens d'émission et de réception sont réalisés au moyen de circuits électroniques qui doivent être alimentés électriquement. Or, pour obtenir des circuits rapides, on choisit des technologies utilisant des transistors bipolaires, comme par exemple la technologie ECL. Il en résulte que la consommation en énergie des circuits au repos n'est pas négligeable et peut provoquer un échauffement exagéré des circuits. Ainsi, dans l'exemple de l'interconnexion entre un grand nombre d'unités, on utilise avantageusement des circuits intégrés pour réaliser l'interface entre chaque unité et les autres du système. Chaque circuit intégré pourra donc comprendre un grand nombre d'émetteurs-récepteurs parmi lesquels quelques uns seulement sont actifs simultanément. Tous ceux qui sont au repos vont donc cumuler des consommations et des échauffements inutiles.

Pour résoudre ce problème, il est donc souhaitable de pouvoir couper l'alimentation des émetteurs-récepteurs, ou du moins leurs circuits de puissance, lorsqu'ils ne sont pas utilisés ni en émission ni en réception.

Il faut cependant que la possibilité de couper l'alimentation des émetteurs-récepteurs permette malgré tout un fonctionnement sûr des transmissions. Ainsi, dans une station considérée où l'alimentation d'un émetteur-récepteur est coupée, il faut toujours pouvoir détecter si la station à laquelle cet émetteur-récepteur est relié émet ou non un signal, car si un signal est émis, il faut alors rétablir immédiatement l'alimentation de l'émetteur-récepteur considéré.

Aussi l'invention a pour but de résoudre ce problème en proposant un procédé de détection de transmission adapté aux liaisons différentielles bi-directionnelles et permettant la coupure d'alimentation des émetteurs-récepteurs.

Plus précisément l'invention a pour objet un procédé de détection de transmission pour système de transmission utilisant au moins un émetteur-récepteur relié par deux lignes de transmission différentielles à un autre émetteur-récepteur analogue, ledit émetteur-récepteur comportant des moyens d'amplification différentielle pour produire des signaux différentiels d'émission et de réception, lesdits moyens d'amplification comportant pour chaque ligne de transmission une impédance d'adaptation à la ligne et connectée à celle-ci, un générateur de signaux d'émission commandé en réponse à des signaux de commande d'émission et alimentant en parallèle ladite impédance et ladite ligne et des moyens de réception pour fournir un signal de mesure qui est représentatif de la somme algébrique du courant circulant dans ladite impédance d'adaptation et d'un courant de compensation tel que ledit signal de mesure ne dépende pratiquement que des signaux d'émission produits par l'autre émetteur-récepteur, l'alimentation desdits moyens d'amplification pouvant être activée ou inhibée en fonction d'un signal de commande d'alimentation, ledit procédé étant caractérisé en ce qu'il consiste, dans chaque émetteur-récepteur, à déterminer une valeur de seuil représentative d'un courant de valeur intermédiaire entre les valeurs maximum et minimum pouvant être prises par les courants représentés par lesdits signaux de mesure, à comparer les signaux de mesure de chaque ligne à ladite valeur de seuil sélectionnée et à produire un signal représentatif de l'activité de la transmission en fonction desdites comparaisons, selon que ladite valeur de seuil est comprise ou non entre les valeurs desdits signaux de mesure.

Pour déterminer si la valeur de seuil est comprise ou non entre les valeurs des signaux de mesure, on peut vérifier si l'un des signaux de mesure représente un courant supérieur en valeur absolue au courant représenté par la valeur de seuil. Si c'est le cas, la transmission est active.

Une autre possibilité équivalente à la précédente consiste à vérifier si les signaux de mesure représentent des courants simultanément inférieurs en valeur absolue au courant représenté par la valeur de seuil. Si c'est le cas, la transmission est inactive.

L'une ou l'autre des possibilités précédentes pourra être choisie en fonction des facilités de mise en oeuvre, selon le contexte et la technologie utilisée. On peut noter que si l'on utilise la technologie ECL, ces deux solutions conduisent à une même réalisation des circuits.

L'invention a également pour objet un circuit de détection de transmission destiné à être associé à un émetteur-récepteur du type défini ci-dessus et spécialement adapté à la mise en oeuvre du procédé selon l'invention. Ce circuit sera caractérisé en ce que, lesdits signaux de mesure étant des tensions, il comprend un générateur de tension fournissant ladite valeur de seuil.

Selon un autre aspect de l'invention, le circuit est caractérisé en ce qu'il comporte deux comparateurs pour comparer respectivement lesdits signaux de mesure à ladite valeur de seuil, les sorties desdits comparateurs étant appliquées à l'entrée d'une porte logique fournissant un signal représentatif de l'activité de la transmission.

Dans certains cas, une seule valeur de seuil n'est pas suffisante pour détecter correctement l'activité de la transmission. Par exemple, si on utilise une compensation par addition, les valeurs maximum et minimum des signaux de mesure dépendront de l'état d'alimentation des moyens d'amplification.

Pour prévoir cette possibilité et selon un autre aspect de l'invention, le circuit est en outre caractérisé en ce que, dans le cas où ladite valeur de seuil dépend de l'état d'alimentation desdits moyens d'amplification dudit émetteur-récepteur, ledit générateur de tension est un générateur de tension variable commandé par ledit signal de commande d'alimentation.

L'invention a également pour objet un circuit intégré comportant une pluralité d'émetteurs-récepteurs du type défini précédemment. Ce circuit intégré comporte des moyens pour activer ou inhiber l'alimentation des moyens d'amplification de chaque émetteur-récepteur par un signal de commande d'alimentation et comprend en outre un circuit de détection de transmission selon l'invention associé à chaque émetteur-récepteur.

D'autres aspects, détails de réalisation et avantages de l'invention seront exposés dans la description qui va suivre.

- La Figure 1 est une représentation schématique d'un dispositif d'émission-réception utilisant le procédé de détection selon l'invention.

- La Figure 2 représente le circuit de détection de transmission.

- La Figure 3 représente une réalisation en technologie ECL des moyens d'amplification différentiels.

- La Figure 4 représente une réalisation en technologie ECL du circuit de détection de transmission selon l'invention.

- La Figure 5 représente une réalisation en technologie ECL d'un circuit de mise en forme des signaux de sortie de l'émetteur-récepteur.

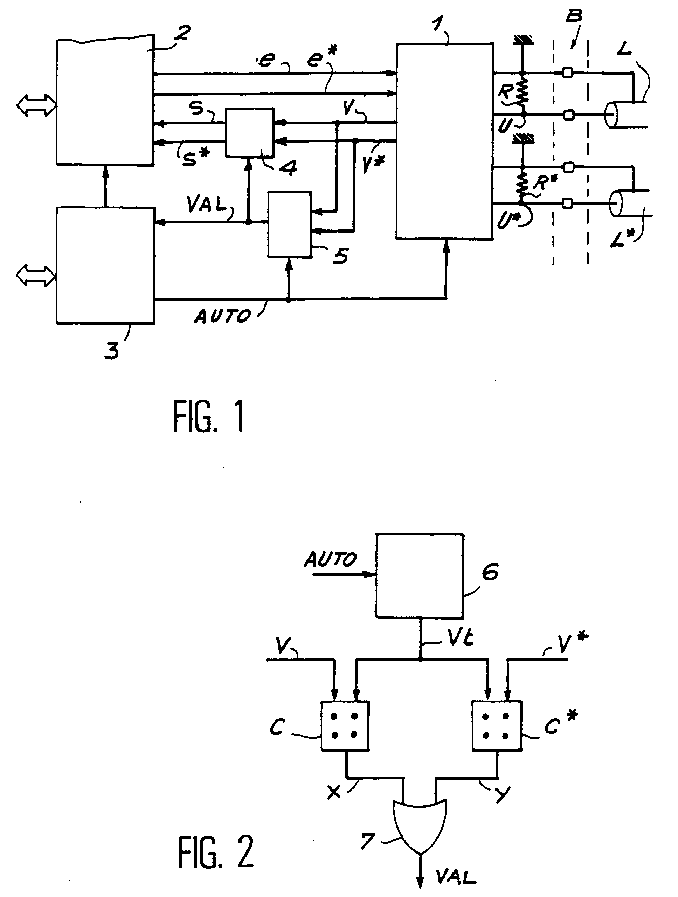

L'ensemble de la Figure 1 représente un dispositif d'émission-réception dans lequel est mis en oeuvre le procédé selon l'invention. A titre d'exemple non limitatif, il consiste en un circuit d'interface parallèle-série, série-parallèle pouvant être utilisé pour réaliser l'interconnexion des unités d'un système informatique. Il sera avantageusement réalisé sous la forme d'un circuit intégré comportant une pluralité d'émetteurs-récepteurs bi-directionnels différentiels.

Sur la figure 1, un seul des émetteurs-récepteurs est représenté. Il se compose d'un amplificateur bidirectionnel différentiel 1 auquel sont associés un circuit de mise en forme 4 et un détecteur de transmission 5 conforme à l'invention. L'amplificateur 1 comporte deux entrées-sorties U, U* différentielles alimentant chacune en parallèle une impédance d'adaptation R, R* et une ligne associé L, L*. La connexion électrique entre les impédances d'adaptation R, R* et les lignes L, L* est effectuée par des bornes B du circuit intégré.

L'amplificateur 1 reçoit en entrée des signaux différentiels de commande d'émission e, e* fournis par un générateur de signaux de commande d'émission 2 qui est, par exemple, un sérialiseur-désérialiseur relié par des entrées/sorties parallèles à une unité associée non représentée.

L'amplificateur 1 fournit les signaux de mesure différentiels V, V* qui sont représentatifs des signaux émis par une autre station reliée à l'extrémité des lignes L, L*.

Un circuit de commande d'alimentation 3 fournit, sous le contrôle de l'unité associée, des signaux AUTO commandant l'alimentation des circuits de puissance de chaque amplificateur . Le circuit 3 peut avantageusement commander aussi l'alimentation du sérialiseur-désérialiseur 2.

Le détecteur de transmission 5 reçoit en entrée les signaux de mesure V, V* ainsi que le signal de commande d'alimentation AUTO et fournit un signal VAL représentatif d'une activité en émission de la station éloignée.

Un circuit de mise en forme 4 reçoit les signaux de mesure V, V* et le signal d'activité VAL et fournit au circuit 2 les signaux différentiels de réception s, s*.

Le circuit de la Figure 1 fonctionne de la façon suivante : en fonctionnement normal, les émetteurs-récepteurs de la station considérée et de la station éloignée sont alimentés. En cas d'absence prolongée d'échanges d'informations entre les deux stations, chaque unité peut envoyer au circuit de commande d'alimentation 3 l'ordre de couper l'alimentation. Si l'alimentation de l'émetteur-récepteur de la station éloignée est coupée, cela se traduit par une absence de signal différentiel V, V* qui est détectée par le circuit 5. Il place par conséquent le signal VAL à 0. Le circuit 4 force alors ses sorties s et s* respectivement à 0 et 1. D'autre part, le signal VAL est transmis par le circuit 3 à l'unité associée. En fonction de critères déterminés, l'unité peut commander la coupure d'alimentation au circuit 3 qui place dans ce cas le signal AUTO à 0.

Si la station éloignée recommence à émettre, l'existence d'une tension différentielle V, V* est détectée par le circuit 5 qui place alors à 1 le signal VAL. Le changement d'état du signal VAL est détecté par le circuit 3 qui maintient ou rétablit automatiquement l'alimentation de l'amplificateur 1 et du sérialiseur-désérialiseur 2 par la mise à 1 du signal AUTO. Par ailleurs, le signal VAL libère le circuit de mise en forme 4 qui fonctionne alors en amplificateur différentiel.

Comme nous le verrons en détail dans la suite de la description, l'entrée AUTO du circuit 5 est prévue dans le cas où les niveaux V, V* dépendent de l'état d'alimentation de l'émetteur-récepteur.

La Figure 2 représente, sous forme de schéma bloc, le circuit de détection de transmission selon l'invention. Il comprend un générateur de seuil 6 fournissant une valeur de seuil Vt fonction de la valeur logique du signal AUTO. Deux comparateurs C et C* comparent respectivement les signaux de mesure V et V* à la valeur de seuil Vt. Les sorties x et y des comparateurs C et C* sont appliquées à l'entrée d'une porte logique 7 dont la sortie fournit le signal d'activité VAL.

Avant d'expliquer le fonctionnement de la Figure 2, il convient de préciser que chaque signal de mesure V ou V* est représentatif de la somme algébrique d'un courant circulant dans l'impédance d'adaptation associée R ou R* d'un courant de compensation de valeur telle que le signal de mesure V, V* ne dépende pratiquement que des signaux d'émission produits par l'autre émetteur-récepteur. Par ailleurs, la valeur de seuil Vt fournie par le générateur 6 est représentative d'un courant de valeur intermédiaire entre les valeurs maximum et minimum pouvant être être prises par les courants représentés par les signaux de mesure V, V*. D'autre part, les entrées des comparateurs C et C* sur lesquelles sont appliqués les signaux V, V* et Vt sont choisies de sorte que chaque sortie x ou y prend la valeur 1 logique lorsque le signal de mesure associé V ou V* représente un courant supérieur en valeur absolue au courant représenté par la valeur de seuil Vt. Dans ce cas, la porte logique 7 est une porte OU et sa sortie VAL prendra la valeur 1 logique lorsqu'il existe un signal différentiel V, V*.

En variante, on pourrait inverser les entrées des comparateurs C, C*. Chaque sortie x ou y prend alors la valeur 1 logique lorsque le signal de mesure associe V ou V* représente un courant inférieur en valeur absolue au courant représenté par la valeur de seuil. Dans ce cas, la porte 7 pourra être une porte ET fournissant un signal d'inactivité VAL*, complément de VAL. Si, par contre, on utilise une porte NI, elle fournira directement le signal VAL.

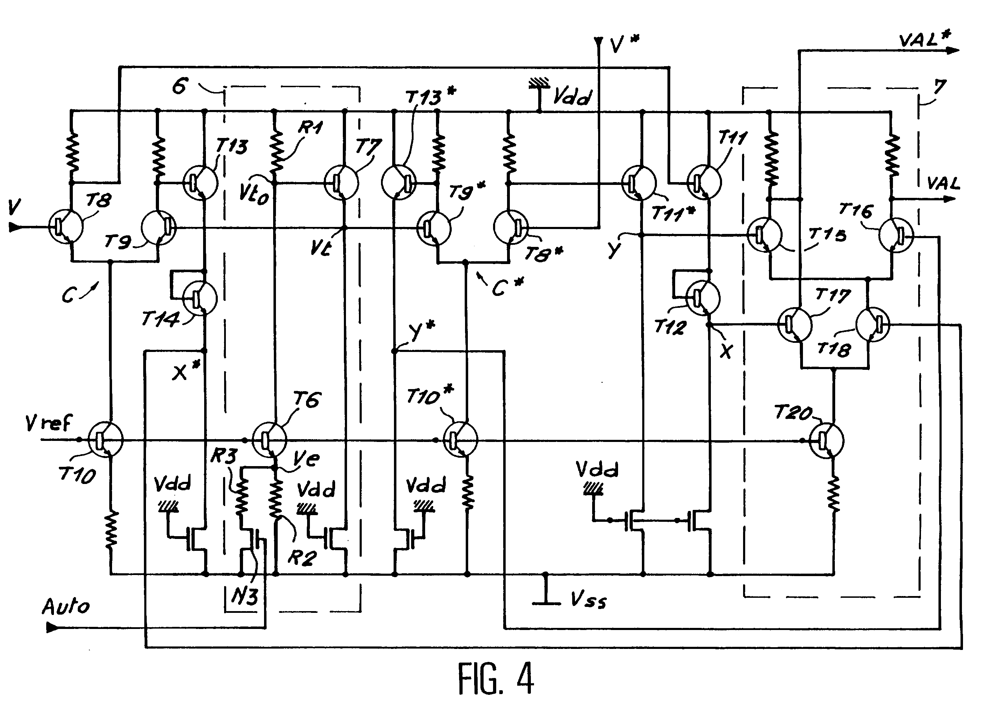

Comme nous le verrons en détail en référence à la figure 4, une réalisation en technologie ECL fournit sur sa sortie différentielle les signaux VAL et VAL* simultanément.

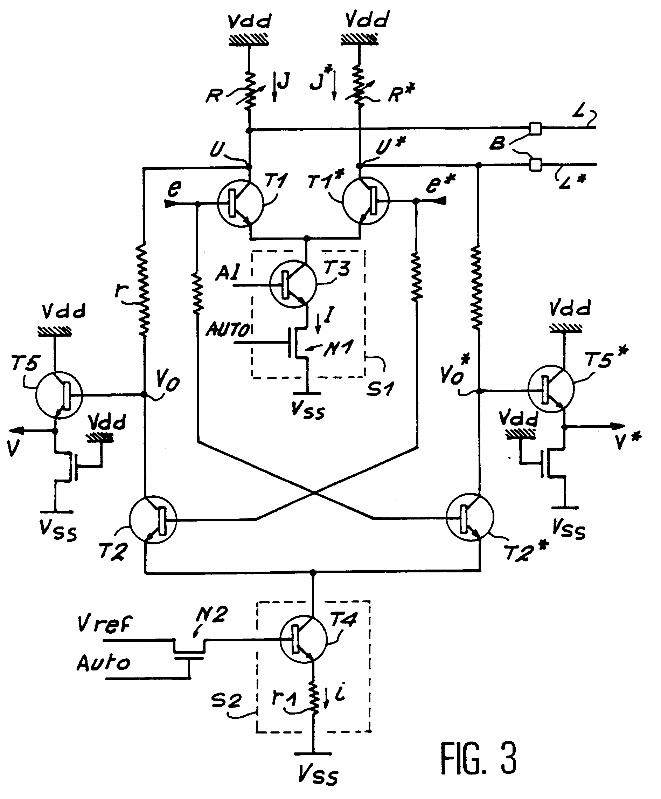

La Figure 3 représente une réalisation particulière en technologie ECL d'un amplificateur bi-directionnel de type différentiel. Il comporte deux voies disposées symétriquement et reliées respectivement aux lignes L, L* de la liaison différentielle. La voie de gauche associée à la ligne L comporte une impédance d'adaptation R dont une borne est reliée au potentiel Vdd de masse et dont l'autre borne est reliée par le point U à la ligne L et au collecteur d'un transistor bipolaire T1 dont l'émetteur est relié à une première source de courant S1 commune aux deux voies. La base du transistor T1 reçoit le signal de commande d'émission e. Le collecteur du transistor T1 est relié au collecteur V0 d'un second transistor T2 par l'intermédiaire d'une impédance r. La base du transistor T2 reçoit le signal e*, complément de e et son émetteur est relié à une seconde source de courant S2 commune aux deux voies. Symétriquement, la voie de droite comporte une impédance d'adaptation R* dont une borne est reliée à la masse et dont l'autre est reliée par le point U* à la ligne L* et au collecteur d'un transistor T1* dont l'émetteur est relié à la source de courant S1. Le collecteur du transistor T1* est relié au collecteur V0* d'un second transistor T2* par l'intermédiaire d'une autre impédance r. L'émetteur du transistor T2* est relié à la seconde source de courant S2. Les transistors T1* et T2* reçoivent respectivement sur leurs bases les signaux e* et e. Les signaux e et e* qui constituent les signaux différentiels de commande d'émission sont complémentaires et représentatifs d'une valeur logique déterminée. Ils sont en fait appliqués respectivement sur la base des transistors T2* et T2 par l'intermédiaire de résistances servant à compenser la constante de temps due à la capacité de structure des impédances R et R*.

La source de courant S1 est constituée d'un transistor bipolaire T3 dont le collecteur est relié aux émetteurs des transistors T1 et T1* et dont l'émetteur est relié au potentiel négatif Vss par l'intermédiaire du chemin drain-source d'un transistor NMOS N1. La base du transistor T3 est commandée par une tension de réglage AI et la grille du transistor N1 reçoit le signal de commande d'alimentation AUTO. De façon analogue, la seconde source de courant S2 est constituée d'un transistor bipolaire T4 dont le collecteur est relié aux émetteurs des transistors T2 et T2* et dont l'émetteur est relié au potentiel Vss par l'intermédiaire d'une résistance r1. La base du transistor T4 est reliée à une tension de polarisation Vref par l'intermédiaire du chemin drain-source d'un transistor NMOS N2 dont la grille est commandée par le signal AUTO. Les collecteurs V0 et V0* des transistors T2 et T2* sont reliés respectivement à l'entrée d'émetteurs-suiveurs constitués respectivement d'un transistor T5 et T5* et d'un transistor NMOS, monté en résistance, reliant l'émetteur du transistor bipolaire au potentiel Vss, les collecteurs des transistors T5 et T5* étant reliés à la masse. Les émetteurs des transistors T5 et T5* constituent les sorties différentielles V, V* de l'amplificateur.

Les valeurs de l'impédance r et des courants i et l sont choisies de façon à vérifier la relation : $r.i = R.l/2$ pour que les tensions au point V0 et V0* ne dépendent pratiquement que des signaux d'émission de la station éloignée. Avantageusement, on prévoira un circuit d'asservissement (non représenté) agissant sur le courant l par la tension de réglage AI en fonction de l'écart entre r.i et R.l/2.

Pour expliquer le fonctionnement du circuit de la figure 3, nous utiliserons la convention de la logique positive, selon laquelle un signal prend la valeur 1 logique lorsque la tension correspondante est haute par rapport au potentiel fixe négatif Vss. Par ailleurs, un signal différentiel tel que e, e* est supposé prendre la valeur l logique, lorsque $e = 1$ et $e* = 0$.

En fonctionnement normal, le signal AUTO est égal à 1. Les sources de courant S1 et S2 sont donc actives et débitent respectivement les courants l et i. Si le signal différentiel de commande d'émission e, e* est à 1, le transistor T1 est passant et le transistor T1* est bloqué. Comme l'impédance d'adaptation R a en principe une valeur égale à l'impédance caractéristique de la ligne L, le transistor T1 injecte dans l'impédance d'adaptation R et dans la ligne un courant voisin de l/2. Si la station éloignée est elle-même active, c'est-à-dire si l'amplificateur bidirectionnel relié à l'extrémité des lignes L, L* est alimenté, un courant pratiquement égal à l/2 (aux pertes près) est injecté dans l'une des impédance R ou R* selon la valeur logique du signal différentiel de commande d'émission appliqué à l'amplificateur éloigné.

D'autre part, le transistor T2* est rendu passant par le signal $e = 1$ appliqué à sa base alors que le transistor T2 est bloqué par le signal $e* = 0$ sur sa base. Un courant i est ainsi injecté dans la résistance r de la branche de droite. Comme 1, i et r sont choisis de façon à avoir la relation $r.i = R.l/2$, les tensions par rapport aux points V0 et V0* prendront respectivement les valeurs -R.l et -R.l/2 ou -R.l/2 et -R.l selon la valeur logique du signal de commande d'émission différentielle de la station éloignée. On peut vérifier aisément que V0 et V0* prennent les mêmes valeurs lorsque la valeur logique du signal différentiel de commande d'émission e, e* est à 0.

Si les deux stations sont au repos, aucun courant n'alimente les impédances R et R*. Les tensions par rapport à la masse aux points V0 et V0* sont donc nulles.

Si par contre, seule la station éloignée est au repos, les tensions aux points V0 et V0* prennent simultanément la valeur -R.l/2.

Si enfin, seule la station considérée est au repos, les tensions au point V0 et V0* prendront respectivement les valeurs -R.l/2 et 0 ou 0 et -R.l/2 selon la valeur logique du signal différentiel de commande d'émission de la station éloignée.

Ainsi, si l'on choisit une première valeur de seuil égale à -R.l/4 ou -3R.l/4 selon que la station considérée est respectivement inactive ou active, il est possible de détecter l'activité de transmission en comparant les tensions au point V0 et V0* à cette valeur de seuil, l'activité étant établie lorsque la tension à l'un des points V0 et V0* est inférieure en valeur algébrique à cette valeur de seuil. De façon équivalente, on peut établir l'inactivité de la transmission si les deux tensions V0, V0* sont simultanément supérieures à cette valeur de seuil

On peut noter qu'un seul seuil serait nécessaire dans le cas où l'amplificateur bidirectionnel réaliserait la compensation par soustraction qui a été mentionnée précédemment.

Les montages émetteur-suiveur T5 et T5* qui servent d'adaptateur d'impédance fournissent les tensions V et V* qui sont appliquées aux entrées différentielles du circuit de détection de transmission 5 réalisé en technologie ECL et représenté à la figure 4.

Le circuit de la figure 4 est composé essentiellement de deux comparateurs de tension C et C* associés respectivement aux signaux V et V*, un générateur de tension de seuil 6 et une porte logique 7.

Le générateur de tension 6 comporte un transistor bipolaire T6 dont la base reçoit une tension de polarisation Vref et dont le collecteur Vto est relié au potentiel de masse Vdd par l'intermédiaire d'une première résistance R1. Son émetteur est relié au potentiel négatif Vss par l'intermédiaire du montage formé d'une seconde résistance R2 branchée en parallèle avec le montage série formé d'une troisième résistance R3 et du chemin drain-source d'un transistor NMOS N3 dont la grille reçoit le signal AUTO. La résistance R3 et le transistor N3 sont ainsi 'équivalents à une résistance pouvant être connectée ou déconnectée du potentiel Vss en fonction du signal AUTO. Cette résistance équivalente a donc une valeur r3 égale à la somme de la résistance R3 et de la résistance du chemin drain-source du transistor N3. Le choix des résistances R1, R2, r3 va permettre d'établir deux niveaux de tension Vto correspondants aux deux valeurs de seuil.

Ainsi, le dimensionnement du générateur 6 pourra être effectué de la façon suivante. Généralement, la valeur du produit R.I est une donnée qui fixe la dynamique des signaux de l'émetteur-récepteur. D'autre part, la tension de polarisation Vref appliquée à la base du transistor T6 est la même que celle appliquée à la base du transistor T4 de la seconde source de courant S2 de l'amplificateur. Par conséquent, la tension d'émetteur du transistor T6 est fixée à la valeur Vref décalée de la chute de tension base-émetteur pratiquement constante du transistor T6. Ainsi, la tension Ve aux bornes de la résistance R2 est fixée et égale à la tension aux bornes de la résistance r1 de la source de courant S2.

Nous avons vu en référence à la figure 3 que les deux valeurs de seuil à utiliser pour cette réalisation particulière étaient les tensions par rapport à la masse égales à -3R.I/4 et -R.I/4 selon que l'amplificateur est alimenté ou non. Par conséquent, les résistances R1, R2 et r3 devront vérifier les équations suivantes :

$$(1) \qquad (R1/R2).Ve = R.I/4$$

$$(2) \qquad R1.(1/R2 + 1/r3).Ve = 3R.I/4$$

On en déduit $r3 = R2/2$ et $R1 = R2.R.I/4Ve$

Si de plus on choisit $r1 = r$ et comme $r.i = R.I/2$, on a $Ve = R.I/2$ et par conséquent $R1 = R2/2$.

Ainsi, en asservissant le courant I de la source de courant S1 au moyen de la tension de base AI du transistor T3 de façon à maintenir en permanence la relation $r.i = R.I/2$, la tension de seuil Vt0 fournie par le générateur 6 prendra les deux valeurs voulues indépendemment des fluctuations des tensions d'alimentation et des dispersions de fabrication.

La tension de seuil Vt0 est appliquée à l'entrée des comparateurs C et C* par l'intermédiaire d'un émetteur-suiveur comprenant le transistor T7 dont le collecteur est relié à la masse et dont l'émetteur est relié au potentiel Vss par la résistance du chemin drain-source d'un transistor NMOS monté en résistance. L'émetteur du transistor T7 fournit la tension Vt qui est égale à la tension Vto décalée de la chute de tension base-émetteur du transistor T7. Ce décalage de tension correspond exactement au décalage entre les tensions V et V0 ou V* et V0* de l'amplificateur de la figure 3. Ainsi, les tensions Vt, V0 et V0* pourront être appliquées directement à l'entrée des comparateurs C et C*.

A l'exception de leurs étages de sortie, les comparateurs C et C* sont de constitutions identiques. Nous décrirons donc seulement le comparateur C, chaque élément homologue du comparateur C* ayant le même signe de référence auquel est associé le symbole *.

Le comparateur C comporte deux transistors T8, T9 reliés entre eux par leur émetteur et dont les collecteurs sont reliés chacun à la masse par l'intermédiaire d'une résistance. Il comporte une source de courant formée du transistor T10 dont l'émetteur est relié au potentiel négatif Vss par l'intermédiaire d'une résistance, son collecteur étant relié aux émetteurs des transistors T8 et T9 et sa base recevant la tension de polarisation Vref. Les collecteurs des transistors T8 et T9 sont reliés respectivement aux entrées de circuits émetteur-suiveur constitués respectivement des transistors T11, T12 et T13, T14 ainsi que de transistors NMOS montés en résistances. Le collecteur du transistor T8 est relié à la base du transistor T11 dont le collecteur est relié à la masse et dont l'émetteur est relié au potentiel Vss par l'intermédiaire du transistor T12 monté en diode et du chemin drain-source d'un transistor NMOS. L'émetteur-suiveur associé au transistor T9 est de constitution identique, les transistors T13 et T14 jouant respectivement le rôle des transistors T11 et T12 de l'émetteur-suiveur précédent. Les émetteurs-suiveurs du comparateur C* sont de constitution analogue mais ne comportent pas les transistors T12 et T14 dont le rôle est de décaler les tensions d'une valeur égale à la tension base-émetteur des transistors bipolaires utilisés dans ce circuit, de façon à adapter les niveaux de tension au circuit aval 7.

Les émetteurs des transistors T12 et T14, respectivement x et x*, constituent la sortie différentielle du comparateur C et les émetteurs y et y* des transistors T11* et T13* constituent celle du comparateur C*. Les points x, x*, y et y* sont appliqués à l'entrée de la porte OU ECL 7. Elle comprend deux transistors T15, T16 reliés entre eux par leur émetteur et dont les collecteurs sont reliés à la masse par l'intermédiaire de résistances. Le collecteur du transistor T15 est relié au collecteur d'un troisième transistor T17 dont l'émetteur est relié à l'émetteur d'un quatrième transistor T18 dont le collecteur est relié aux émetteurs des transistors T15 et T16. Les émetteurs des transistors T17 et T18 sont reliés au collecteur du transistor T20 dont l'émetteur est relié au potentiel Vss par l'intermédiaire d'une résistance. La base de ce transistor T20 reçoit la tension de polarisation Vref. Les points x, x*, y et y* sont reliés respectivement aux bases des transistors T17, T18, T15, et T16. Les collecteurs des transistors T16 et T15 constituent la sortie différentielle de la porte 7 et fournissent le signal différentiel d'activité VAL, VAL*.

Le circuit de la figure 4 fonctionne de la façon suivante. Lorsque l'émetteur-récepteur de la station éloignée n'est pas alimenté, les tensions V et V* sont, par rapport à la masse, algébriquement supérieures à la valeur de seuil Vt. Les transistors T8 et T8* sont donc conducteurs et les transistors T9 et T9* sont bloqués. Les transistors T11 et T11* sont donc bloqués tandis que les transistors T13 et T13* sont passants. Les sorties différentielles x, x* et y, y* des comparateurs C et C* prennent donc la valeur 0 logique. Les transistors T15 et T17 sont donc bloqués et les transistors T16 et T18 sont passants. La tension VAL* du collecteur du transistor T15 est égale au potentiel de masse Vdd et la tension VAL du collecteur T16 prend une valeur inférieure, ce qui signifie que le signal différentiel VAL, VAL* représente la valeur 0 logique.

Si par contre, la station éloignée est active, une seule des tensions V ou V* est inférieure à la valeur de seuil Vt. Il en résulte que l'un des transistors T15 ou T17 est passant et que l'un des transistors T16 ou T18, respectivement, est bloqué. La sortie différentielle VAL, VAL* prend donc la valeur 1 logique.

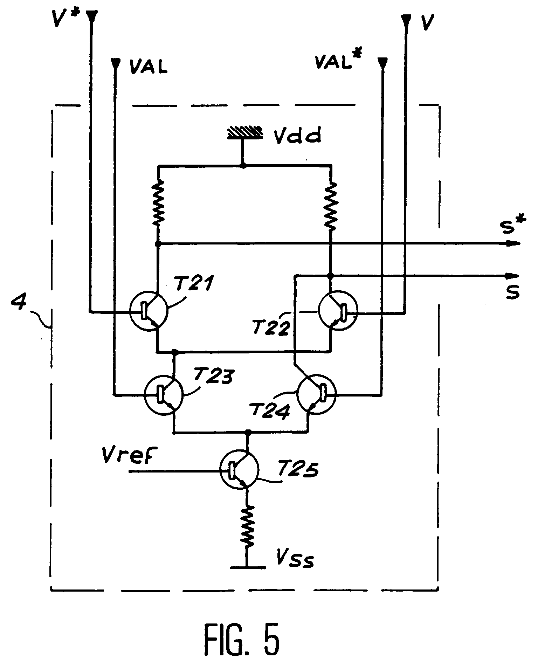

La figure 5 représente une réalisation du circuit de mise en forme 4 des signaux de sortie de l'émetteur-récepteur. Ce circuit est une porte ET en technologie ECL composée de deux transistors T21, T22 reliés entre eux par leur émetteur et dont les collecteurs sont reliés chacun à la masse par l'intermédiaire d'une résistance. Deux autres transistors T23, T24 ont leur émetteur relié au collecteur d'un cinquième transistor T25 dont l'émetteur est relié au potentiel Vss par l'intermédiaire d'une résistance. Le collecteur du transistor T23 est relié aux émetteurs des transistors T21 et T22 tandis que le collecteur du transistor T24 est relié au collecteur du transistor T22. La base du transistor T25 reçoit la tension de polarisation Vref. Les bases des transistors T21 et T22 reçoivent respectivement les tensions V* et V. Les bases des transistors T23 et T24 reçoivent respectivement les signaux d'activité de ligne VAL et VAL* qui sont fournis par le circuit de la figure 4 par l'intermédiaire d'un circuit de décalage des niveaux de tension non représenté. Les tensions s* et s des collecteurs des transistors T21 et T22 constituent les signaux de réception différentiels utilisables en aval dans le reste du circuit.

Concernant le fonctionnement du circuit de la figure 5, il est facile de vérifier qu'il fonctionne en amplificateur différentiel lorsque le signal différentiel VAL, VAL* prend la valeur 1 logique car le transistor T23 est passant et le transistor T24 est bloqué. Si par contre, VAL, VAL* prend la valeur 0 logique, le transistor T23 est bloqué et le transistor T24 est passant. Il en résulte que le signal s est à l'état bas et le signal s* est à l'état haut, forçant ainsi la sortie différentielle du circuit à la valeur 0 logique.

**Revendications**

1. Procédé de détection de transmission pour système de transmission utilisant au moins un émetteur-récepteur relié par deux lignes de transmission différentielles (L, L*) à un autre émetteur-récepteur analogue, ledit émetteur-récepteur comportant des moyens d'amplification différentielle (1) pour produire des signaux différentiels d'émission et de réception, lesdits moyens d'amplification (1) comportant pour chaque ligne de transmission (L, L*) une impédance (R, R*) d'adaptation à la ligne et connectée à celle-ci, un générateur de signaux d'émission (T1, T1*, S1) commandé en réponse à des signaux de commande d'émission (e, e*) et alimentant en parallèle ladite impédance (R, R*) et ladite ligne (L, L*) et des moyens de réception (T2, T2*, r, S2) pour fournir un signal de mesure (V, V*) qui est représentatif de la somme algébrique du courant circulant dans ladite impédance d'adaptation (R, R*) et d'un courant de compensation tel que ledit signal de mesure (V, V*) ne dépende pratiquement que des signaux d'émission produits par l'autre émetteur-récepteur, l'alimentation desdits moyens d'amplification (1) pouvant être activée ou inhibée en fonction d'un signal de commande d'alimentation (AUTO), ledit procédé étant caractérisé en ce qu'il consiste, dans chaque émetteur-récepteur, à déterminer une valeur de seuil (Vt) représentative d'un courant de valeur intermédiaire entre les valeurs maximum et minimum pouvant être prises par les courants représentés par lesdits signaux de mesure (V, V*), à comparer les signaux de mesure de chaque ligne à ladite valeur de seuil déterminée (Vt) et à produire un signal représentatif de l'activité (VAL, VAL*) de la transmission en fonction desdites comparaisons, selon que ladite valeur de seuil (Vt) est comprise ou non entre les valeurs desdits signaux de mesure (V, V*).

2. Procédé selon la revendication 1, caractérisé en ce qu'un signal d'activité (VAL) est produit lorsque l'un desdits signaux de mesure (V, V*) représente un courant supérieur en valeur absolue au courant représenté par ladite valeur de seuil (Vt).

3. Procédé selon la revendication 1, caractérisé en ce qu'un signal d'inactivité (VAL*) est produit lorsque lesdits signaux de mesure (V, V*) représentent des courants simultanément inférieurs en valeur absolue au courant représenté par ladite valeur de seuil (Vt).

4. Circuit de détection de transmission pour système de transmission comprenant au moins un émetteur-récepteur relié par deux lignes de transmission différentielles (L, L*) à un autre émetteur-récepteur analogue, ledit émetteur-récepteur comportant des moyens d'amplification différentielle (1) pour produire des signaux différentiels d'émission et de réception, lesdits moyens d'amplification (1) comportant pour chaque ligne de transmission (L, L*) une impédance (R, R*) d'adaptation à la ligne et connectée à celle-ci, un générateur de signaux d'émission (T1, T1*, S1) commandé en réponse à des signaux de commande d'émission (e, e*) et alimentant en parallèle ladite impédance (R, R*) et ladite ligne (L, L*) et des moyens de réception (T2, T2*, r, S2) pour fournir un signal de mesure (V, V*) qui est représentatif de la somme algébrique du courant circulant dans ladite impédance d'adaptation (R, R*) et d'un courant de compensation tel que ledit signal de mesure (V, V*) ne dépend pratiquement que des signaux d'émission produits par l'autre émetteur-récepteur, l'alimentation desdits moyens d'amplification (1) pouvant être activée ou inhibée en fonction d'un signal de commande d'alimentation (AUTO), ledit circuit de détection de transmission étant caractérisé en ce qu'il comprend un générateur de tension (6) fournissant une valeur de seuil (Vt) représentative d'un courant de valeur intermédiaire entre les valeurs maximum et minimum pouvant être prises par les courants représentés en tension par lesdits signaux de mesure (V, V*), des moyens pour comparer les signaux de mesure de chaque ligne à ladite valeur de seuil (Vt) et à produire un signal représentatif de l'activité (VAL, VAL*) de la transmission en fonction desdites comparaisons, selon que ladite valeur de seuil (Vt) est comprise ou non entre les valeurs desdits signaux de mesure (V, V*).

5. Circuit selon la revendication 4, caractérisé en ce qu'il comporte deux comparateurs (C, C*) pour comparer respectivement lesdits signaux de mesure (V, V*) à ladite valeur de seuil (Vt), les sorties desdits comparateurs étant appliquées à l'entrée d'une porte logique (7) fournissant un signal (VAL, VAL*) représentatif de l'activité de la transmission.

6. Circuit selon l'une des revendications 4 ou 5, caractérisé en ce que, dans le cas où ladite valeur de seuil (Vt) dépend de l'état d'alimentation desdits moyens d'amplification (1) dudit émetteur-récepteur, ledit générateur de tension (6) est un générateur de tension variable commandé par ledit signal de commande d'alimentation (AUTO).

7. Circuit selon la revendication 6, caractérisé en ce que ledit générateur de tension (6) comporte un transistor bipolaire (T6) dont la base est polarisée par une tension fixe (Vref), dont le collecteur est relié à un premier potentiel (Vdd) par l'intermédiaire d'une première résistance (R1) et dont l'émetteur est relié à un second potentiel (Vss) par l'intermédiaire d'un montage formé d'une seconde résistance (R2) branchée en parallèle avec une troisième résistance (R3, N3) pouvant être déconnecté en réponse audit signal de commande d'alimentation (AUTO), le potentiel (Vto) du collecteur dudit transistor (T6) étant représentatif de ladite valeur de seuil (Vt).

8. Circuit selon la revendication 7, caractérisé en ce que ladite troisième résistance est réalisée au moyen d'une résistance (R3) en série avec un transistor MOS (N3) recevant sur sa grille ledit signal de commande d'alimentation (AUTO).

9. Circuit intégré comportant une pluralité d'émetteurs-récepteurs reliés chacun par deux lignes de transmission différentielles (L, L*) à un autre émetteur-récepteur analogue, lesdits émetteurs-récepteurs comportant des moyens d'amplification différentielle (1) pour produire des signaux différentiels d'émission et de réception sur lesdites lignes, lesdits moyens d'amplification (1) comportant pour chaque ligne une impédance (R, R*) d'adaptation à la ligne et connectée à celle-ci, un générateur de signaux d'émission (T1, T1*, S1) commandé en réponse à des signaux de commande d'émission (e, e*) et alimentant en parallèle ladite impédance (R, R*) et ladite ligne (L, L*) et des moyens de réception (T2, T2*, r, S2) pour fournir un signal de mesure (V, V*) qui est représentatif de la somme algébrique du courant circulant dans ladite impédance d'adaptation (R, R*) et d'un courant de compensation tel que ledit signal de mesure (V, V*) ne dépend pratiquement que des signaux d'émission produits par l'autre émetteur-récepteur, ledit circuit intégré étant caractérisé en ce qu'il comporte des moyens (3, S1, S2) pour activer ou inhiber l'alimentation desdits moyens d'amplification (1) de chaque émetteur-récepteur par un signal de commande d'alimentation (AUTO) et en ce qu'il comprend un circuit de détection de transmission (5) associé à chaque émetteur-récepteur, le circuit de détection de transmission (5) comprenant un générateur de tension (6) fournissant une valeur de seuil (Vt) représentative d'un courant de valeur intermédiaire entre les valeurs maximum et minimum pouvant être prises par les courants représentés en tension par lesdits signaux de mesure (V, V*) et des moyens pour comparer les signaux de mesure de chaque ligne à ladite valeur de seuil (Vt) et à produire un signal représentatif de l'activité (VAL, VAL*) de la transmission en fonction desdites comparaisons, selon que ladite valeur de seuil (Vt) est comprise ou non entre les valeurs desdits signaux de mesure (V, V*).

10. Circuit intégré selon la revendication 9, caractérisé en ce que le circuit de détection de transmission 5 comporte deux comparateurs (C, C*) pour comparer respectivement lesdits signaux de mesure (V, V*) à ladite valeur de seuil (Vt), les sorties desdits comparateurs étant appliquées à l'entrée d'une porte logique (7) fournissant un signal (VAL, VAL*) représentatif de l'activité de la transmission.

11. Circuit intégré selon l'une des revendications 9 ou 10, caractérisé en ce que, dans le cas où ladite valeur de seuil (Vt) dépend de l'état d'alimentation desdits moyens d'amplification (1) dudit émetteur-récepteur, ledit générateur de tension (6) est un générateur de tension variable commandé par ledit signal de commande d'alimentation (AUTO).

12. Circuit intégré selon la revendication 11, caractérisé en ce que ledit générateur de tension (6) comporte un transistor bipolaire (T6) dont la base est polarisée par une tension fixe (Vref), dont le collecteur est relié à un premier potentiel (Vdd) par l'intermédiaire d'une première résistance (R1) et dont l'émetteur est relié à un second potentiel (Vss) par l'intermédiaire d'un montage formé d'une seconde résistance (R2) branchée en parallèle avec une troisième résistance (R3, N3) pouvant être déconnecté en réponse audit signal de commande d'alimentation (AUTO), le potentiel (Vto) du collecteur dudit transistor (T6) étant représentatif de ladite valeur de seuil (Vt).

13. Circuit intégré selon la revendication 12, caractérisé en ce que ladite troisième résistance est réalisée au moyen d'une résistance (R3) en série avec un transistor MOS (N3) recevant sur sa grille ledit signal de commande d'alimentation (AUTO).

## Patentansprüche

1. Übertragungserfassungsverfahren für ein Übertragungssystem, das wenigstens einen Sender-Empfänger verwendet, der durch zwei differentielle Übertragungsleitungen (L, L*) mit einem weiteren, analogen Sender-Empfänger verbunden ist, wobei der Sender-Empfänger Mittel zur differentiellen Verstärkung (1) enthält, um differentielle Sende- und Empfangssignale zu erzeugen, wobei die Verstärkungsmittel (1) für jede Übertragungsleitung (L, L*) eine Impedanz (R, R*) für die Anpassung an die Leitung, mit der sie verbunden ist, einen Sendesignalgenerator (T1, T1*, S1), der als Antwort auf Sendesteuersignale (e, e*) gesteuert wird und die Impedanz (R, R*) und die Leitung (L, L*) parallel versorgt, sowie Empfangsmittel (T2, T2*, r, S2) enthalten, die ein Meßsignal (V, V*) liefern, das die algebraische Summe S des in der Anpassungsimpedanz (R, R*) fließenden Stroms und eines Kompensationsstroms repräsentiert, derart, daß das Meßsignal (V, V*) im wesentlichen nur von den vom anderen Sender-Empfänger erzeugten Sendesignalen abhängt, wobei die Versorgung der Verstärkungsmittel (1) in Abhängigkeit von einem Versorgungssteuersignal (AUTO) aktiviert oder gesperrt wird, wobei das Verfahren dadurch gekennzeichnet ist, daß es in jedem Sender-Empfänger darin besteht, daß ein Schwellenwert (Vt) bestimmt wird, der einen Stromwert repräsentiert, der zwischen den Maximal-und Minimalwerten liegt, die von den durch die Meßsignale (V, V*) repräsentierten Strömen angenommen werden können, daß die Meßsignale jeder Leitung mit dem bestimmten Schwellenwert (Vt) verglichen werden und daß ein Signal erzeugt wird, das die Aktivität (VAL, VAL*) der Übertragung in Abhängigkeit von den Vergleichen repräsentiert, je nachdem, ob der Schwellenwert (Vt) zwischen den Werten der Meßsignale (V, V*) liegt oder nicht.

2. Verfahren nach Anspruch 1, dadurch gekennzeichnet, daß ein Aktivitätssignal (VAL) erzeugt wird, wenn eines der Meßsignale (V, V*) einen Strom repräsentiert, dessen Absolutwert größer als der Strom ist, der durch den Schwellenwert (Vt) repräsentiert wird.

3. Verfahren nach Anspruch 1, dadurch gekennzeichnet, daß ein Inaktivitätssignal (VAL*) erzeugt wird, wenn die Meßsignale (V, V*) Ströme repräsentieren, deren Absolutwerte gleichzeitig kleiner sind als der Strom, der durch den Schwellenwert (Vt) repräsentiert wird.

4. Übertragungserfassungsschaltung für Übertragungssystem, das wenigstens einem Sender-Empfänger verwendet, der durch zwei differentielle Übertragungsleitungen (L, L*) mit einem weiteren, analogen Sender-Empfänger verbunden ist, wobei der Sender-Empfänger Mittel zur differentiellen Verstärkung (1) enthält, um differentielle Sende- und Empfangssignale zu erzeugen, wobei die Verstärkungsmittel (1) für jede Übertragungsleitung (L, L*) eine Impedanz (R, R*) für die Anpassung an die Leitung, mit der sie verbunden ist, einen Sendesignalgenerator (T1, T1*, S1), der als Antwort auf Sendesteuersignale (e, e*) gesteuert wird und die Impedanz (R, R*) und die Leitung (L, L*) parallel versorgt, sowie Empfangsmittel (T2, T2*, r, S2) enthalten, die ein Meßsignal (V, V*) liefern, das die algebraische Summe des in der Anpassungsimpedanz (R, R*) fließenden Stroms und eines Kompensationsstroms repräsentiert, derart, daß das Meßsignal (V, V*) im wesentlichen nur von den vom anderen Sender-Empfänger erzeugten Sendesignalen abhängt, wobei die Versorgung der Verstärkungsmittel (1) in Abhängigkeit von einem Versorgungssteuersignal (AUTO) aktiviert oder gesperrt werden kann, wobei die Übertragungserfassungsschaltung dadurch gekennzeichnet ist, daß sie einen Spannungsgenerator (6), der einen Schwellenwert (Vt) liefert, der einen Stromwert repräsentiert, der zwischen den Maximal- und Minimalwerten liegt, die von den Strömen angenommen werden können, die als Spannung durch die Meßsignale (V, V*) repräsentiert werden, sowie Mittel enthält, um die Meßsignale jeder Leitung mit dem Schwellenwert (Vt) zu vergleichen und ein Signal zu erzeugen, das die Aktivität (VAL, VAL*) der Übertragung in Abhängigkeit von diesen Vergleichen repräsentiert, je nachdem, ob der Schwellenwert (Vt) zwischen den Werten der Meßsignale (V, V*) liegt oder nicht.

**5.** Schaltung nach Anspruch 4, dadurch gekennzeichnet, daß sie zwei Komparatoren (C, C*) enthält, um die jeweiligen Meßsignale (V, V*) mit dem Schwellenwert (Vt) zu vergleichen, wobei die Ausgänge der Komparatoren in den Eingang eines Logikgatters (7) eingegeben werden, das ein Signal (VAL, VAL*) liefert, das die Aktivität der Übertragung repräsentiert.

**6.** Schaltung nach einem der Ansprüche 4 oder 5, dadurch gekennzeichnet, daß in dem Fall, in dem der Schwellenwert (Vt) vom Zustand der Versorgung der Verstärkungsmittel (1) des Sender-Empfängers abhängt, der Spannungsgenerator (6) ein variabler Spannungsgenerator ist, der durch das Versorgungssteuersignal (AUTO) gesteuert wird.

**7.** Schaltung nach Anspruch 6, dadurch gekennzeichnet, daß der Spannungsgenerator (6) einen Bipolartransistor (T6) enthält, wovon die Basis durch eine feste Spannung (Vref) vorgespannt ist, wovon der Kollektor über einen ersten Widerstand (R1) mit einem ersten Potential (Vdd) verbunden ist und wovon der Emitter über eine Schaltung, die durch einen zweiten Widerstand (R2) gebildet ist, der zu einem dritten Widerstand (R3, N3) parallelgeschaltet ist, der als Antwort auf das Versorgungssteuersignal (AUTO) abgekoppelt werden kann, mit einem zweiten Potential (Vss) verbunden ist, wobei das Potential (Vto) des Kollektors des Transistors (T6) den Schwellenwert (Vt) repräsentiert.

**8.** Schaltung nach Anspruch 7, dadurch gekennzeichnet, daß der dritte Widerstand durch einen Widerstand (R3) verwirklicht ist, der mit einem MOS-Transistor (N3) in Serie geschaltet ist, der an seinem Gate das Versorgungssteuersignal (AUTO) empfängt.

**9.** Integrierte Schaltung mit mehreren Sender-Empfängern, die jeweils über zwei differentielle Übertragungsleitungen (L, L*) mit einem weiteren analogen Sender-Empfänger verbunden sind, wobei die Sender-Empfänger Mittel zur differentiellen Verstärkung (1) enthalten, um auf den Leitungen differentielle Sende- und Empfangssignale zu erzeugen, wobei die Verstärkungsmittel (1) für jede Leitung eine Impedanz (R, R*) für die Anpassung an die Leitung, mit der sie verbunden ist, einen Sendesignalgenerator (T1, T1*, S1), der als Antwort auf Sendesteuersignale (e, e*) gesteuert wird und die Impedanz (R, R*) und die Leitung (L, L*) parallel versorgt, sowie Empfangsmittel (T2, T2*, r, S2) enthalten, die ein Meßsignal (V, V*) liefern, das die algebraische Summe des in der Anpassungsimpedanz (R, R*) fließenden Stroms und eines Kompensationsstroms repräsentiert, derart, daß das Meßsignal (V, V*) im wesentlichen nur von den Sendesignalen abhängt, die vom anderen Sender-Empfänger erzeugt werden, wobei die integrierte Schaltung dadurch gekennzeichnet ist, daß sie Mittel (3, S1, S2) zum Aktivieren oder Sperren der Versorgung der Verstärkungsmittel (1) jedes Sender-Empfängers durch ein Versorgungssteuersignal (AUTO) enthält und daß sie eine Übertragungserfassungsschaltung (5) enthält, die zu jedem Sender-Empfänger gehört, wobei die Übertragungserfassungsschaltung (5) einen Spannungsgenerator (6), der einen Schwellenwert (Vt) liefert, der einen Stromwert repräsentiert, der zwischen den Maximal- und Minimalwerten liegt, die von den Strömen angenommen werden können, die als Spannung durch die Meßsignale (V, V*) repräsentiert werden, sowie Mittel enthält, die die Meßsignale jeder Leitung mit dem Schwellenwert (Vt) vergleichen und ein Signal erzeugen, das die Aktivität (VAL, VAL*) der Übertragung in Abhängigkeit von den Vergleichen repräsentieren, je nachdem, ob der Schwellenwert (Vt) zwischen den Werten der Meßsignale (V, V*) liegt oder nicht.

**10.** Integrierte Schaltung nach Anspruch 9, dadurch gekennzeichnet, daß die Übertragungserfassungsschaltung (5) zwei Komparatoren (C, C*) enthält, die die jeweiligen Meßsignale (V, V*) mit dem Schwellenwert (Vt) vergleichen, wobei die Ausgänge der Komparatoren in den Eingang eines Logikgatters (7) eingegeben werden, das ein die Aktivität der Übertragung repräsentierendes Signal (VAL, VAL*) liefert.

**11.** Integrierte Schaltung nach einem der Ansprüche 9 oder 10, dadurch gekennzeichnet, daß in dem Fall, in dem der Schwellenwert (Vt) vom Zustand der Versorgung der Verstärkungsmittel (1) des Sender-Empfängers abhängt, der Spannungsgenerator (6) ein variabler Spannungsgenerator ist, der durch das Versorgungssteuersignal (AUTO) gesteuert wird.

**12.** Integrierte Schaltung nach Anspruch 11, dadurch gekennzeichnet, daß der Spannungsgenerator (6) einen Bipolartransistor (T6) enthält, wovon die Basis durch eine feste Spannung (Vref) vorgespannt ist, wovon der Kollektor über einen ersten Widerstand (R1) mit einem ersten Potential (Vdd) verbunden ist und wovon der Emitter über eine Schaltung, die durch einen zweiten Widerstand (R2) gebildet ist, der zu einem dritten Widerstand (R3, N3) parallelgeschaltet ist, der als Antwort auf das Versorgungssteuersignal (AUTO) abgekoppelt werden kann, mit einem zweiten Potential (Vss) verbunden ist, wobei das Potential (Vto) des Kollektors des Transistors (T6) den Schwellenwert (Vt) repräsentiert.

**13.** Integrierte Schaltung nach Anspruch 12, dadurch gekennzeichnet, daß der dritte Widerstand durch einen Widerstand (R3) verwirklicht ist, der mit einem MOS-Transistor (N3) in Serie geschaltet ist, der an seinem Gate das Versorgungssteuersignal (AUTO) empfängt.

## Claims

1. A transmission detection method for a transmission system using at least one transceiver linked by two differential transmission lines (L, L*) to another analogous transceiver, said transceiver comprising differential amplification means (1) for producing differential transmission and reception signals, said amplification means (1) comprising, for each transmission line (L, L*), an impedance (R, R*) for matching to the line and connected thereto, a generator of transmission signals (T1, T1*, S1) controlled in response to transmission control signals (e, e*) and supplying in parallel said impedance (R, R*) and said line (L, L*), and reception means (T2, T2*, r, S2) for supplying a measurement signal (V, V*) representing the algebraic sum of the current flowing through said matching impedance (R, R*) and a compensation current such that said measurement signal (V, V*) depends in practice only on the transmission signals produced by the other transceiver, it being possible for the supply to said amplification means (1) to be activated or inhibited as a function of a supply control signal (AUTO), said method being characterised in that it consists, in each transceiver, of determining a threshold value (Vt) representing a current of a value intermediate between the maximum and minimum values that can be taken by the currents represented by said measurement signals (V, V*), of comparing the measurement signals for each line with said determined threshold value (Vt) and of producing a signal representing the activity (VAL, VAL*) of the transmission as a function of said comparisons, depending on whether or not said threshold value (Vt) is comprised between the values of said measurement signals (V, V*).

2. A method according to Claim 1, characterised in that an activity signal (VAL) is produced when one of said measurement signals (V, V*) represents a current of a greater absolute value than the current represented by said threshold value (Vt).

3. A method according to Claim 1, characterised in that an inactivity signal (VAL*) is produced when said measurement signals (V, V*) represent currents simultaneously of a lower absolute value than the current represented by said threshold value (Vt).

4. A transmission detection circuit for a transmission system using at least one transceiver linked by two differential transmission lines (L, L*) to another analogous transceiver, said transceiver comprising differential amplification means (1) for producing differential transmission and reception signals, said amplification means (1) comprising, for each transmission line (L, L*), an impedance (R, R*) for matching to the line and connected thereto, a generator of transmission signals (T1, T1*, S1) controlled in response to transmission control signals (e, e*) and supplying in parallel said impedance (R, R*) and said line (L, L*), and reception means (T2, T2*, r, S2) for supplying a measurement signal (V, V*) representing the algebraic sum of the current flowing through said matching impedance (R, R*) and a compensation current such that said measurement signal (V, V*) depends in practice only on the transmission signals produced by the other transceiver, it being possible for the supply to said amplification means (1) to be activated or inhibited as a function of a supply control signal (AUTO), said transmission detection circuit being characterised in that it comprises a voltage generator (6) supplying a threshold value (Vt) representing a current of a value intermediate between the maximum and minimum values that can be taken by the currents represented as to voltage by said measurement signals (V, V*), means for comparing the measurement signals for each line with said threshold value (Vt) and of producing a signal representing the activity (VAL, VAL*) of the transmission as a function of said comparisons, depending on whether or not said threshold value (Vt) is comprised between the values of said measurement signals (V, V*).

5. A circuit according to Claim 4, characterised in that it comprises two comparators (C, C*) for comparing respectively said measurement signals (V, V*) with said threshold value (Vt), the outputs of said comparators being applied to the input of a logic gate (7) supplying a signal (VAL, VAL*) representing the transmission activity.

6. A circuit according to one of Claims 4 or 5, characterised in that, where said threshold value (Vt) depends on the state of supply to said amplification means (1) of said transceiver, said voltage generator (6) is a variable voltage generator controlled by said supply control signal (AUTO).

7. A circuit according to Claim 6, characterised in that said voltage generator (6) comprises a bipolar transistor (T6), the base of which is biased by a fixed voltage (Vref), the collector of which is linked to a first potential (Vdd) via a first resistor (R1), and the emitter of which is linked to a second potential (Vss) via an assembly formed by a second resistor (R2) connected in parallel with a third resistor (R3, N3) that can be disconnected in response to said supply control signal (AUTO), the potential (Vto) of the collector of said transistor (T6) representing said threshold value (Vt).

8. A circuit according to Claim 7, characterised in that said third resistor is produced by means of a resistor (R3) in series with an MOS transistor (N3) receiving said supply control signal (AUTO) at its gate.

9. An integrated circuit comprising a plurality of transceivers each linked by two differential transmission lines (L, L*) to another analogous transceiver, said transceivers comprising differential amplification means (1) for producing differential transmission and reception signals on said lines, said amplification means (1) comprising, for each line, an impedance (R, R*) for matching to the line and connected thereto, a generator of transmission signals (T1, T1*, SI) controlled in response to transmission control signals (e, e*) and supplying in parallel said impedance (R, R*) and said line (L, L*), and reception means (T2, T2*, r, S2) for supplying a measurement signal (V, V*) representing the algebraic sum of the current flowing through said matching impedance (R, R*) and a compensation current such that said measurement signal (V, V*) depends in practice only on the transmission signals produced by the other transceiver, said integrated circuit being characterised in that it comprises means (3, S1, S2) for activating or inhibiting the supply to said amplification means (1) of each transceiver by a supply control signal (AUTO), and in that it comprises a transmission detection circuit (5) associated with each transceiver, the transmission detection circuit (5) comprising a voltage generator (6) supplying a threshold value (Vt) representing a current of a value intermediate between the maximum and minimum values that can be taken by the currents represented as to voltage by said measurement signals (V, V*) and means for comparing the measurement signals for each line with said threshold value (Vt) and of producing a signal representing the activity (VAL, VAL*) of the transmission as a function of said comparisons, depending on whether or not said threshold value (Vt) is comprised between the values of said measurement signals (V, V*).

10. An integrated circuit according to Claim 9, characterised in that the transmission detection circuit 5 comprises two comparators (C, C*) for comparing respectively said measurement signals (V, V*) with said threshold value (Vt), the outputs of said comparators being applied to the input of a logic gate (7) supplying a signal (VAL, VAL*) representing the transmission activity.

11. An integrated circuit according to one of Claims 9 or 1 0, characterised in that, where said threshold value (Vt) depends on the supply state of said amplification means (1) of said transceiver, said voltage generator (6) is a variable voltage generator controlled by said supply control signal (AUTO).

12. An integrated circuit according to Claim 11, characterised in that said voltage generator (6) comprises a bipolar transistor (T6), the base of which is biased by a fixed voltage (Vref), the collector of which is linked to a first potential (Vdd) via a first resistor (R1) and the emitter of which is linked to a second potential (Vss) via an assembly formed of a second resistor (R2) connected in parallel with a third resistor (R3, N3) that can be disconnected in response to said supply control signal (AUTO), the potential (Vto) of the collector of said transistor (T6) representing said threshold value (Vt).

13. An integrated circuit according to Claim 12, characterised in that said third resistor is produced by means of a resistor (R3) in series with an MOS transistor (N3) receiving said supply control signal (AUTO) at its gate.

FIG. 1

FIG. 2

FIG. 3

FIG. 4

FIG. 5